# EUROPEAN PATENT SPECIFICATION

(11) **EP 0 626 614 B1**
(45) Date of publication and mention of the grant of the patent: **04.08.1999**
(21) Application number: 93201510.0
(22) Date of filing: 26.05.1993
(51) Int. Cl.: G03C 1/28, G03F 7/07, G03C 8/06

(54) **A red-sensitive silver halide photographic material**
Rotempfindliches photographisches Silberhalogenidmaterial
Matériau photographique à l'halogénure d'argent sensible dans le rouge

(43) Date of publication of application: 30.11.1994
(73) Proprietor: AGFA-GEVAERT N.V., 2640 Mortsel (BE)
(72) Inventor: Deprez, Lode, c/o Agfa-Gevaert N.V., DIE 3800, B-2640 Mortsel (BE)

(56) References cited:
- JP-A- 4 365 030
- US-A- 2 843 490
- US-A- 3 297 446

## Description

### 1. Field of the invention.

The present invention relates to a silver halide photographic material sensitive to light sources emitting light between 600nm and 700nm. The present invention further relates to a method for obtaining images with said photographic material and to a method for obtaining a lithographic printing plate with said photographic material.

### 2. Background of the invention.

With recent rapid progress of information transmitting systems, silver halide photographic light sensitive materials have been increasingly required to have high sensitivity. Such systems are, for example, high speed phototypesetting systems according to which information output from an electronic computer is immediately displayed as letters or figures by a cathode ray tube and press facsimile systems for rapid transmission of newspaper originals to a remote place.

Photographic phototypesetting materials include photographic films and papers used in a process for preparing a lithographic printing plate and silver salt diffusion transfer based lithographic printing plates disclosed in e.g. US-P-4,501,811 and US-P-4,784,933. With the latter materials a lithographic printing plate is immediately obtained without the need of a contact exposure or camera exposure.

Todate on the market phototypesetters usually work with a He/Ne laser (632nm), laser diode (680nm) or LED (670nm or 780nm). Especially phototypesetters that operate with a He/Ne laser or LED (670-680nm) are frequently employed.

For a photographic material to be suitable for use in phototypesetting applications it is required that the material is of high speed to so-called high intensity-short time exposure (flash exposure or scanning exposure), namely exposure for 10⁻⁴ second or less and yields images of high contrast and high resolving power: therefore the emulsion grains contain rhodium and usually iridium dopants.

However, red-light sensitive materials are generally not so high in sensitivity and inferior in shelf stability and various proposals have been made in an attempt to solve these problems. For example, a technique called supersensitization has been proposed according to which spectral sensitivity is markedly enhanced by adding a specifically selected organic compound in addition to the spectral sensitizing dye. Reference may be made to, for example, triazine derivatives disclosed in U.S-P-2,785,058 and 3,695,888, and mercapto compounds having (a) electronegative group(s) disclosed in U.S-P-3,457,078. However, many of these supersensitization techniques provide unsatisfactory results such as insufficient sensitization, slower development, increase of fog and decrease in shelf stability.

Another research direction tried in the past in order to achieve optimization of the grain-fog-sensitivity relationship implied the addition of a water-soluble salt in some particular stage of the emulsion preparation. For instance, US-P-2,839,405 discloses the use of several metal salts for improvement of fog and stability of bromoiodide emulsions. The salt is added after chemical and spectral sensitization. US-P-2,843,490 describes the addition of a cadmium or zinc salt (chloride or bromide) during spectral sensitization with a specifically meso-substituted carbocyanine dye; sensitivity and stability are claimed to be improved. US-P-3,804,634 discloses the combination of a merocyanine dye and a divalent cadmium salt. US-P-3,837,862 claims a combination of a cyanine and a merocyanine dye ; some particular inorganic salts can be present.

To obtain a photographic material of high speed at the wavelengths at which phototypesetters operate the total amount of dye(s) should be kept as low as possible.

When the photographic material is to be used in a silver salt diffusion transfer process and especially for preparing printing plates according to this process it is further required that there is no interference of the spectral sensitization with the diffusion transfer process that may cause a weak and/or low contrast silver image to be formed as occurs in many instances with red-light sensitive spectral sensitizers. When the silver image is intended to be used as a printing plate a weak and/or low contrast silver image may cause bad printing properties such as low printing endurance, low ink acceptance in the printing areas, unwanted ink acceptance in the non printing areas both during start-up of the printing process (toning) and during printing (staining).

US-P-4,743,525 discloses that silver salt diffusion transfer based lithographic printing plates should comprise at least one lime treated gelatin-containing layer wherein the content of calcium ion is 1000 ppm or less in order to obtain a high printing endurance.

From the above it may be said that it is difficult to sensitize a photographic material for light in the range between 600 nm and 700 nm so that it obtains the necessary speed for phototypesetting applications and at the same time ful-filling the other requirements imposed on such photographic materials. So,further improvements in the spectral sensitization of these materials is still desirable.

### 3. Summary of the invention.

It is an object of the present invention to provide a photographic material comprising a silver halide emulsion spectrally sensitized to wavelenghts in the red spectrum i.e. between 600nm and 700nm having a high sensitivity and that yields images of high contrast and high resolving power.

It is another object of the present invention to provide a method for obtaining an image with said photographic material. It is another object of the present invention to provide a method for obtaining a lithographic printing plate according to the silver salt diffusion transfer process using said photographic material.

Further objects of the present invention will become clear from the description hereinafter.

According to the present invention there is provided a photographic material comprising a silver halide emulsion layer sensitized to red light by means of an anionic sensitizing dye having a maximum absorption between 600nm and 700nm characterized in that said silver halide emulsion further comprises a salt of a group IIa metal,added during the spectral sensitization.

According to the present invention there is provided a photographic material comprising on a support a red sensitized silver halide emulsion and an image receiving layer containing physical development nuclei characterized in that said silver halide emulsion is red sensitized using an anionic sensitizing dye having a maximum absorption between 600nm and 700nm and further comprises a salt of a group IIa metal,added during the spectral sensitization in an amount of at least 5*10⁻³ mole/mole of silver halide, the anion of said salt can form with a silver cation a salt with a solubility product in water higher than 10⁻⁸ mole²/liter².

According to the present invention there is provided a method for obtaining an image with the above defined photographic materials using high intensity short time exposure followed by development.

According to the present invention there is provided a method for obtaining a lithographic printing plate according to the silver salt diffusion transfer process by high intensity short time exposure followed by development of a photographic material as defined above.

### 4. Detailed description of the invention.

It has been found that a photographic material comprising a red sensitized silver halide emulsion using an anionic sensitizing dye having a maximum absorption between 600nm and 700nm and further comprising a salt of a group IIa metal,added during the spectral sensitization yields images of high contrast and high resolution. Furthermore the photographic material has a high sensitivity towards phototypesetters employing a He/Ne laser or LED emitting at 670nm to 680nm, which enables the use of smaller silver halide grains or less sensitizer which is beneficial in a DTR-process.

Red sensitizing dyes of the anionic type suitable for use in accordance with the present invention are the anionic red sensitizing dyes commonly employed e.g. the anionic dyes described by F.M. Hamer in "The Cyanine Dyes and Related Compounds", 1964, John Wiley & Sons. These dyes can be used alone or in a mixture of two or more of these dyes.

Preferred red sensitizing dyes correspond to one of the following formulas (I) to (IV): 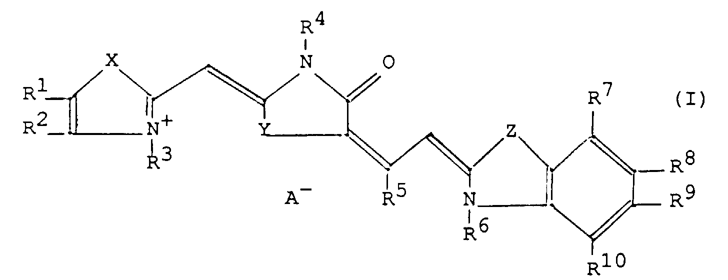 wherein each of X and Z independently represents S, Se or O, Y represents S, Se or NR with R representing a substituted or non-substituted alkyl, a substituted or non-substituted cycloalkyl or a substituted or non-substituted aryl, each of R³, R⁴ and R⁶ independently represents allyl or a substituted or non-substituted C₁-C₄ alkyl, R⁵ represents hydrogen, a substituted or non-substituted alkyl, a substituted or non-substituted aralkyl or a substituted or non-substituted aryl, R¹ and R² each independently represents a substituted or non-substituted alkyl, a substituted or non-substituted aralkyl, a substituted or non-substituted aryl, a substituted or non-substituted alkoxy or R¹ and R² together represent the necessary atoms to complete a ring system, including a fused ring system that may contain one or more heteroatoms, that may be aromatic and that may be substituted by one or more substituents selected from the group consisting of a substituted or non-substituted alkyl, halogen, and a substituted or non-substituted alkoxy, each of R⁷, R⁸, R⁹, R¹⁰ independently represents hydrogen, a substituent selected from the group consisting of a substituted or non-substituted alkyl, a substituted or non-substituted aralkyl, a substituted or non-substituted aryl, halogen, -CN, ester, hydroxyl, a substituted or non-substituted alkoxy, -NH₂, -NHR', -NR'₂ with R' representing a substituted or non-substituted alkyl, a substituted or non-substituted cycloalkyl or a substituted or non-substituted aryl or R⁷ and R⁸ or R⁸ and R⁹ or R⁹ and R¹⁰ together represent the necessary atoms to complete a ring system, including a fused ring system that may contain one or more heteroatoms and that may be aromatic, and A⁻ represents an anion, e.g. F⁻, Cl⁻, Br⁻, I⁻, toluene sulphonate, ClO₄⁻ ,
and wherein at least one of the substituents represented by R³, R⁴ or R⁶ are C₁-C₄ alkyl substituted with a COOM or SO₃M group with M representing hydrogen, a metal cation or NH₄⁺; 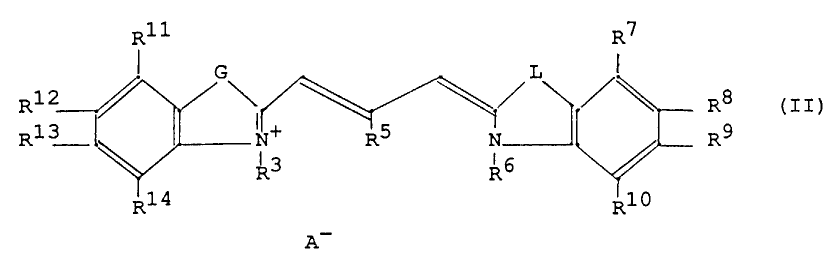 wherein R³, R⁵, R⁶, R⁷, R⁸, R⁹, R¹⁰ and A⁻ have the same meaning as defined above, each of G and L independently represents S, Se, O or C(CH₃)₂ and R¹¹, R¹², R¹³ and R¹⁴ independently from R⁷, R⁸, R⁹ and R¹⁰ may have one of the significances given for R⁷, R⁸, R⁹ and R¹⁰ and wherein at least one of the substituents represented by R³, or R⁶ are C₁-C₄ alkyl substituted with a COOM or SO₃M group with M having the same meaning as defined above; 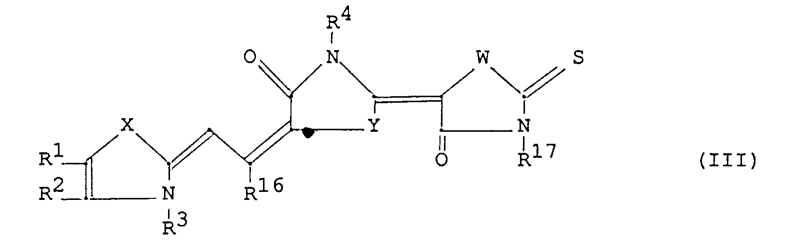 wherein X, Y, R¹, R², R³, R⁴, R⁵ and R⁶ have the same meaning as defined above, W represents S, Se or NR¹⁵ with R¹⁵ representing an allyl or a substituted or non-substituted C₁-C₄ alkyl, R¹⁶ independently from R¹⁵ has the same meaning as R¹⁵ and R¹⁷ independently from R¹⁵ has the same meaning as R¹⁵ or represents a substituted or non-substituted aryl
and wherein at least one of the substituents represented by R³, R⁴, R¹⁵, R¹⁶ or R¹⁷ are C₁-C₄ alkyl substituted with a COOM or SO₃M group with M having the same meaning as defined above; 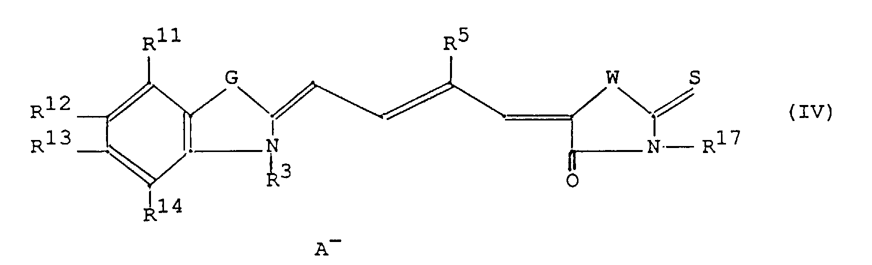 wherein G, W, R³, R⁵, R¹¹, R¹², R¹³, R¹⁴ and R¹⁷ have the same meaning as defined above
and wherein at least one of the substituents represented by R³ or R¹⁷ are C₁-C₄ alkyl substituted with a COOM or SO₃M group with M having the same meaning as defined above;

Examples of red sensitizing dyes according to formula (III) are shown in respectively tables 1, 2, 3 and 4. Further examples according to formula (III) may be found in EP-A-427,892.

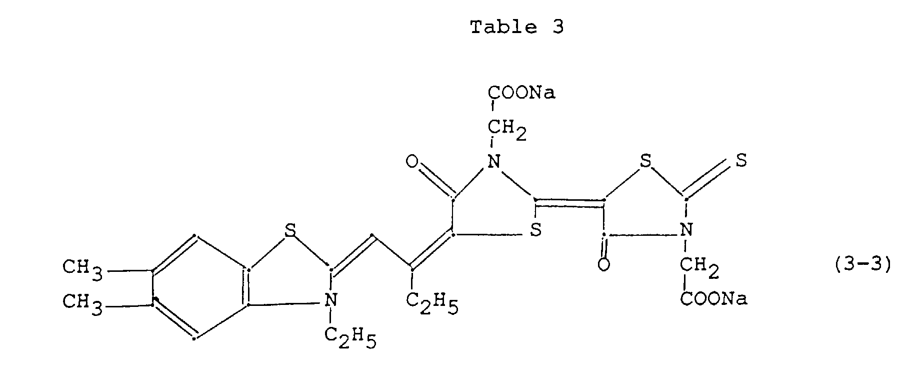

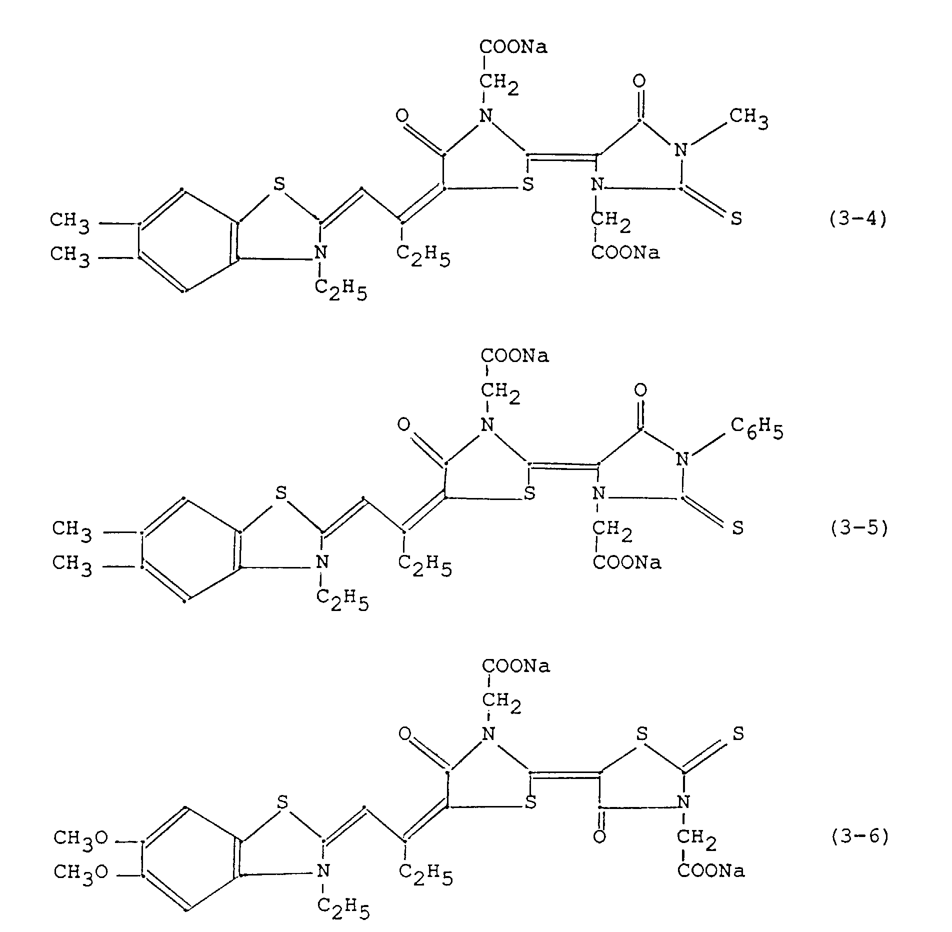

The red sensitizing dyes are preferably added to the silver halide emulsion in a total amount of 1*10⁻⁵ mole/mole of silver halide to 1*10⁻³ mole/mole of silver halide. When amounts less than 1*10⁻⁵ mole/mole of silver halide are used the desired sensitivity at 632 (He/Ne) and/or 670-680nm may not be obtained while amounts larger than 1*10⁻³ mole/mole of silver halide may yield silver halide emulsions of low stability due to fogging. The optimal amount of red sensitizing dye to be used in accordance with the present invention depends on the silver halide composition, average grain size and crystal habit of the silver halide grain, type of sensitizing dyes etc..

Salts of the group IIa metals suitable for use in accordance with the present invention may be any salt or oxide of the commonly used group IIa metals e.g. magnesium, calcium, strontium and barium.

Preferably water-soluble magnesium and calcium salts are used.

Most preferably water-soluble magnesium and calcium salts are used the anion of which can form with a silver cation a salt with a solubility product in water higher than 10⁻⁸ mole²/liter².

The silver halide emulsion comprises the salt of a group IIa metal in an amount of at least 5*10⁻³ mole/mole of silver halide. The upper limit is not very important but is preferably not higher than 2 mole/mole of silver halide.

More preferably the salt of a group IIa metal is used in an amount between 1*10⁻² mole/mole of silver halide and 1 mole/mole of silver halide.

Most preferably the salt of a group IIa metal is used in an amount between 4*10⁻² mole/mole of silver halide and 0.2 mole/mole of silver halide.

The silver halide emulsion according to the present invention may further comprise a so-called supersensitizing compound i.e. a compound that shows no substantial absorption in the sensitivity range of the dye mixture used in accordance with the present invention and whereby said supersensitizing compound increases the sensitivity in the red region. Suitable supersensitizing compounds for use in accordance with the present invention are disclosed in e.g. Research Disclosure Vol 289, May 1988, item 28952, US-P-5,009,991, US-P-4,910,129, US-P-2,785,058, US-P-3,695,888, US-P-3,457,078 etc.. Said supersensitizing compound or compounds are preferably used in a total amount of 5*10⁻⁵ mole/mole silver halide to 1*10⁻³ mole/mole of silver halide. Too small amounts of supersensitizing compound may yield silver halide emulsion of low sensitivity and low stability while too large amounts of supersensitizing compound(s) may also yield low sensitivity due to a reduced development rate of the silver halide.
Preferably used supersensitizing compounds are of the 1-phenyl-5-mercapto-tetrazole type or of the 2-mercaptobenzthiazole type. Specific examples of supersensitizing compounds are:

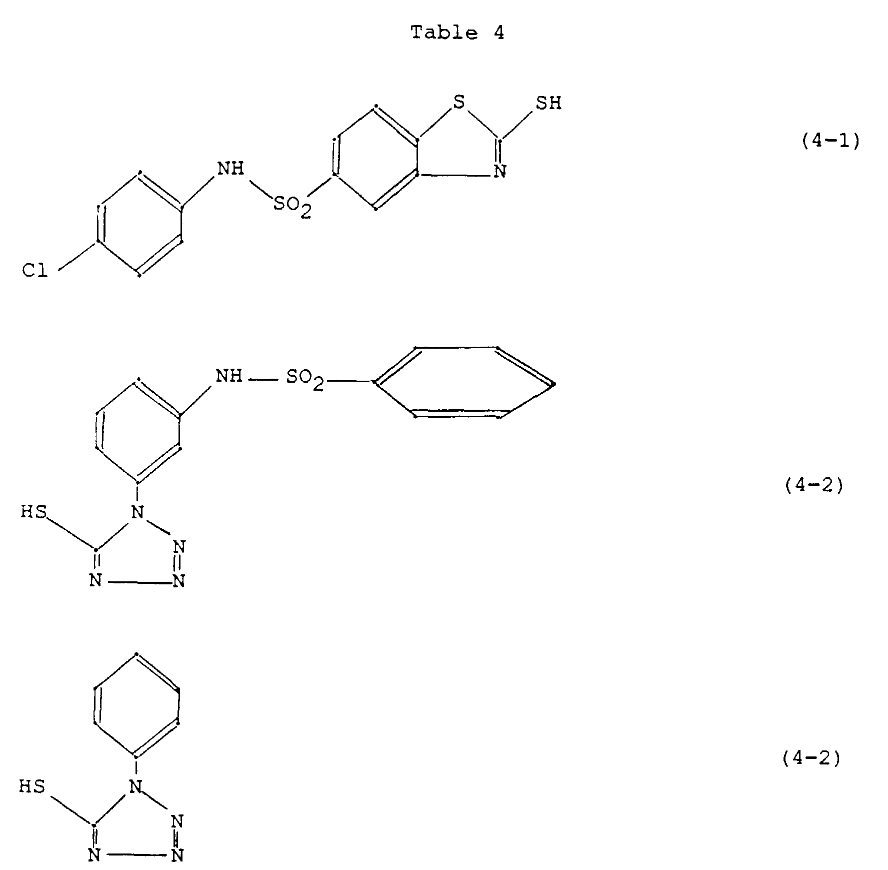

Spectral sensitization of the silver halide emulsion is preferably carried out as a last step in the preparation of the silver halide emulsion. The metal salt, the red sensitizing dye, and supersensitizing compound may be sequentially added in any order or simultaneously to the silver halide emulsion during sensitization. However the metal salt is preferably added first followed by the supersensitizer and then by the red sensitizing dye.

The photographic silver halide emulsions can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

The photographic silver halide emulsions used according to the present invention can be prepared by mixing the halide and silver solutions in partially or fully controlled conditions of temperature, concentrations, sequence of addition, and rates of addition. The silver halide can be precipitated according to the single-jet method or the double-jet method.

The silver halide particles of the photographic emulsions used according to the present invention may have a regular crystalline form such as a cubic or octahedral form or they may have a transition form. They may also have an irregular crystalline form such as a spherical form or a tabular form, or may otherwise have a composite crystal form comprising a mixture of said regular and irregular crystalline forms.

To take most advantage of the present invention the emulsion or emulsions preferably consist principally of silver chloride preferably at least 70 mole% while a fraction of silver bromide may be present up to 30 mole%. When silver chlorobromide emulsions are used they preferably belong to the core/shell type well known to those skilled in the art in the sense that substantially all the bromide is concentrated in the core. This core contains preferably 10 to 40 % of the total silver halide precipitated, while the shell consists preferably of 60 to 90 % of the total silver halide precipitated. The silver halide may also contain small amounts of iodide i.e. upto 3%.

The average size of the silver halide grains may range from 0.10 to 0.70 µm, preferably from 0.20 to 0.45 µm.

The size distribution of the silver halide particles of the photographic emulsions to be used according to the present invention can be homodisperse or heterodisperse. A homodisperse size distribution is obtained when 95% of the grains have a size that does not deviate more than 30% from the average grain size.

Preferably during the precipitation stage iridium and/or rhodium containing compounds or a mixture of both are added. The concentration of these added compounds ranges from 10⁻⁸ to 10⁻³ mole per mole of AgNO₃, preferably between 10⁻⁷ and 10⁻⁶ mole per mole of AgNO₃. This results in the building in in the silver halide crystal lattice of minor amounts of iridium and/or rhodium, so-called iridium and/or rhodium dopants. As known to those skilled in the art numerous scientific and patent publications disclose the addition of iridium or rhodium containing compounds or compounds containing other elements of Group VIII of the Periodic System during emulsion preparation.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-P-493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

The silver halide emulsions may contain the usual stabilizers e.g. homopolar or salt-like compounds of mercury with aromatic or heterocyclic rings such as mercaptotriazoles, simple mercury salts, sulphonium mercury double salts and other mercury compounds. Other suitable stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable stabilizers are i.a. heterocyclic mercapto compounds e.g. phenylmercaptotetrazole, quaternary benzothiazole derivatives, and benzotriazole. Preferred compounds are mercapto substituted pyrimidine derivatives as disclosed in US-P-3,692,527.

The silver halide emulsions may contain pH controlling ingredients. Preferably the emulsion layer is coated at a pH value below the isoelectric point of the gelatin to improve the stability characteristics of the coated layer. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P-4,092,168, US-P-4,311,787 and DE-P-2,453,217.

In an especially preferred embodiment the emulsion layer contained in the imaging element contains a compound which comprises in its molecular structure a group capable of adsorbing to silver halide and a group capable of reducing silver halide. Compounds of this kind have been disclosed in EP-A-449,340. In this way a combination of a stabilizing and a development activating function in one compound is achieved. A preferred compound belonging to this class is represented by the following formula:

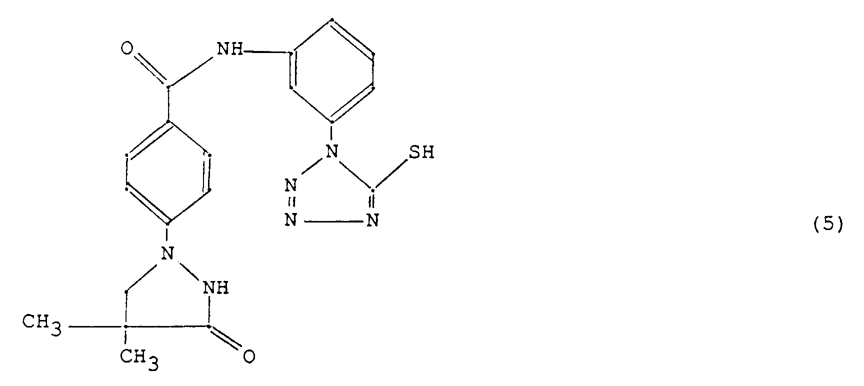

More details about the composition, preparation and coating of silver halide emulsions can be found in e.g. Product Licensing Index, Vol. 92, December 1971, publication 9232, p. 107-109.

In addition to the above described emulsion layer other hydrophilic colloid layers in water permeable relationship with these layers may be present. For example it is especially advantageous to include a base-layer between the support and the photosensitive silver halide emulsion layer. In a preferred embodiment of the present invention said base-layer serves as an antihalation layer. This layer can therefore contain the same light-absorbing dyes as described above for the emulsion layer; as alternative finely divided carbon black can be used for the same antihalation purposes as described in US-P-2,327,828. On the other hand, in order to gain sensitivity, light reflecting pigments, e.g. titaniumdioxide can be present. Further this layer can contain hardening agents, matting agents, e.g. silica particles, and wetting agents. At least part of these matting agents and/or light reflection pigments may also be present in the silver halide emulsion layer the most part however preferably being present in said base-layer. As a further alternative the light reflecting pigments may be present in a separate layer provided between the antihalation layer and the photosensitive silver halide emulsion layer.

In a preferred embodiment in connection with the present invention a backing layer is provided at the non-light sensitive side of the support. This layer which can serve as anti-curl layer can contain i.a. matting agents e.g. silica particles, lubricants, antistatic agents, light absorbing dyes, opacifying agents, e.g. titanium oxide and the usual ingredients like hardeners and wetting agents. The backing layer can consist of one single layer or a double layer pack.

The hydrophilic layers usually contain gelatin as hydrophilic colloid binder. Mixtures of different gelatins with different viscosities can be used to adjust the rheological properties of the layer. Like the emulsion layer the other hydrophilic layers are coated preferably at a pH value below the isoelectric point of the gelatin. Gelatin can, however, be replaced in part or integrally by synthetic, semi-synthetic, or natural polymers. Synthetic substitutes for gelatin are e.g. polyvinyl alcohol, poly-N-vinyl pyrrolidone, polyvinyl imidazole, polyvinyl pyrazole, polyacrylamide, polyacrylic acid, and derivatives thereof, in particular copolymers thereof. Natural substitutes for gelatin are e.g. other proteins such as zein, albumin and casein, cellulose, saccharides, starch, and alginates. In general, the semi-synthetic substitutes for gelatin are modified natural products e.g. gelatin derivatives obtained by conversion of gelatin with alkylating or acylating agents or by grafting of polymerizable monomers on gelatin, and cellulose derivatives such as hydroxyalkyl cellulose, carboxymethyl cellulose, phthaloyl cellulose, and cellulose sulphates.

The hydrophilic layers of the photographic element, especially when the binder used is gelatin, can be hardened with appropriate hardening agents such as those of the epoxide type, those of the ethylenimine type, those of the vinylsulfone type e.g. 1,3-vinylsulphonyl-2-propanol, chromium salts e.g. chromium acetate and chromium alum, aldehydes e.g. formaldehyde, glyoxal, and glutaraldehyde, N-methylol compounds e.g. dimethylolurea and methyloldimethylhydantoin, dioxan derivatives e.g. 2,3-dihydroxy-dioxan, active vinyl compounds e.g. 1,3,5-triacryloyl-hexahydro-s-triazine, active halogen compounds e.g. 2,4-dichloro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts of the type, described in US-P-4,063,952.

Preferably used hardening agents are of the aldehyde type. The hardening agents can be used in a wide concentration range but are preferably used in an amount of 4% to 7% by weight of the hydrophilic colloid. Different amounts of hardener can be used in the different layers of the imaging element or the hardening of one layer may be adjusted by the diffusion of a hardener from another layer.

The imaging element used according to the present invention may further comprise various kinds of surface-active agents in the photographic emulsion layer or in at least one other hydrophilic colloid layer. Suitable surface-active agents include non-ionic agents such as pluronics, saponins, alkylene oxides e.g. polyethylene glycol, polyethylene glycol/polypropylene glycol condensation products, polyethylene glycol alkyl ethers or polyethylene glycol alkylaryl ethers, polyethylene glycol esters, polyethylene glycol sorbitan esters, polyalkylene glycol alkylamines or alkylamides, silicone-polyethylene oxide adducts, glycidol derivatives, fatty acid esters of polyhydric alcohols and alkyl esters of saccharides; anionic agents comprising an acid group such as a carboxy, sulpho, phospho, sulphuric or phosphoric ester group; ampholytic agents such as aminoacids, aminoalkyl sulphonic acids, aminoalkyl sulphates or phosphates, alkyl betaines, and amine-N-oxides; and cationic agents such as alkylamine salts, aliphatic, aromatic, or heterocyclic quaternary ammonium salts, aliphatic or heterocyclic ring-containing phosphonium or sulphonium salts. Preferably compounds containing perfluorinated alkyl groups are used. Such surface-active agents can be used for various purposes e.g. as coating aids, as compounds preventing electric charges, as compounds improving slidability, as compounds facilitating dispersive emulsification and as compounds preventing or reducing adhesion.

The photographic material of the present invention may further comprise various other additives such as e.g. compounds improving the dimensional stability of the photographic element, UV-absorbers, spacing agents and plasticizers.

Suitable additives for improving the dimensional stability of the photographic element are e.g. dispersions of a water-soluble or hardly soluble synthetic polymer e.g. polymers of alkyl (meth)acrylates, alkoxy(meth)acrylates, glycidyl (meth)acrylates, (meth)acrylamides, vinyl esters, acrylonitriles, olefins, and styrenes, or copolymers of the above with acrylic acids, methacrylic acids, alpha-beta-unsaturated dicarboxylic acids, hydroxyalkyl (meth)acrylates, sulphoalkyl (meth)acrylates, and styrene sulphonic acids.

Supports suitable for use in accordance with the present invention may be opaque or transparent, e.g. a paper support or resin support. When a paper support is used preference is given to one coated at one or both sides with an alpha-olefin polymer, e.g. a polyethylene layer which optionally contains an anti-halation dye or pigment. It is also possible to use an organic resin support e.g. cellulose nitrate film, cellulose acetate film, poly(vinyl acetal) film, polystyrene film, poly(ethylene terephthalate) film, polycarbonate film, polyvinylchloride film or poly-alpha-olefin films such as polyethylene or polypropylene film. The thickness of such organic resin film is preferably comprised between 0.07 and 0.35 mm. These organic resin supports are preferably coated with a hydrophilic adhesion layer which can contain water insoluble particles such as silica or titanium dioxide. Metal supports such as e.g. aluminium, zinc, steel etc., may also be used in accordance with the photographic element of the present invention.

According to a preferred method of the present invention the above described photographic material element is information-wise exposed using a scanning exposure beam between 600nm and 700nm and is subsequently developed in an alkaline processing liquid in the presence of developing agents.

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidinone-type developing agent and/or p-monomethylaminophenol. Particularly useful auxiliary developing agents are of the phenidone type e.g. 1-phenyl-3-pyrazolidinone, 1-phenyl-4-monomethyl-3-pyrazolidinone, and 1-phenyl-4,4-dimethyl-3-pyrazolidinone. However other developing agents can be used. Said developing agents may be contained in an alkaline processing liquid but are preferably contained in one or more layers of the imaging element. In the latter case the alkaline processing liquid merely serves as an alkaline activating liquid.

The pH of said activating liquid is preferably between 10 and 14 and may be established by an organic and/or inorganic alkali agent. Examples of suitable alkali agents are e.g. sodium hydroxide, carbonates, secundary and/or tertiary alkanolamines, amines etc. or mixtures thereof.

The alkaline processing liquid preferably also contains a preserving agent having antioxidation activity, e.g. sulphite ions provided e.g. by sodium or potassium sulphite. For example, the aqueous alkaline solution comprises sodium sulphite in an amount ranging from 0.15 to 1.0 mole/l. Further may be present a thickening agent, e.g. hydroxyethylcellulose and carboxymethylcellulose, fog inhibiting agents, e.g. potassium bromide, potassium iodide and a benzotriazole which is known to improve the printing endurance, calcium-sequestering compounds, anti-sludge agents, and hardeners including latent hardeners.

Development acceleration can be accomplished with the aid of various compounds to the alkaline processing liquid and/or one or more layers of the photographic element, preferably polyalkylene derivatives having a molecular weight of at least 400 such as those described in e.g. US-P-3,038,805, 4,038,075, 4,292,400 and 4,975,354.

The above described development step is preferably followed by a washing step, a fixing step and another washing or stabilizing step. The first washing step may be omitted.

The photographic material of the present invention may also be used in the silver salt diffusion transfer process. The principles of the silver complex diffusion transfer reversal process, hereinafter called DTR-process, have been described e.g. in US-P-2,352,014 and the book "Photographic Silver Halide Diffusion Processes" by André Rott and Edith Weyde - The Focal Press -London and New York, (1972).

According to the DTR process, a silver complex salt is image-wise transferred by diffusion from the image-wise exposed silver halide emulsion layer into an image receiving layer, where it is converted to a silver image usually in the presence of physical development nuclei. For this purpose, the image-wise exposed silver halide emulsion layer is developed in the presence of a developing agent and non-developed silver halide is converted by means of a silver halide complexing agent into a soluble silver complex salt while in contact with an image receiving layer.

At the exposed areas of the silver halide emulsion layer the silver halide is developed (chemical development) and thus cannot be dissolved anymore to diffuse to the receiving layer.

At the unexposed areas of the silver halide emulsion layer the silver halide is converted to a soluble silver complex salt and is transferred to the receiving layer, where it forms a silver image usually in the presence of physical development nuclei.

Suitable silver complexing agents also called silver halide solvents for use in accordance with the present invention are e.g. thiosulphate or thiocyanate. Further interesting silver halide complexing agents, are cyclic imides, preferably combined with alkanolamines, as described in US-P-4,297,430 and US-P-4,355,090 and 2-mercaptobenzoic acid derivatives as described in US-P-4,297,429, preferably combined with alkanolamines or with cyclic imides and alkanolamines. Further interesting silver halide solvents for use in accordance with the present invention are described in US-P-5,200,294, US Serial No. 07/810,146, US Serial No. 07/810,151 and US Serial No. 07/986,071. Said silver halide solvent(s) can be present in one or more layers comprised in the imaging element but are preferably comprised in the alkaline processing liquid.

Preferred physical development nuclei for use in accordance with the present invention are sulphides of heavy metals e.g. sulphides of antimony, bismuth, cadmium, cobalt, lead, nickel, palladium, platinum, silver, and zinc. Especially suitable physical development nuclei in connection with the present invention are palladium sulphide nuclei. Other suitable physical development nuclei are salts such as e.g. selenides, polyselenides, polysulphides, mercaptans, and tin (II) halides. Heavy metals, preferably silver, gold, platinum, palladium, and mercury can be used in colloidal form.

A DTR-image bearing material can be used as a planographic printing plate wherein the DTR-silver image areas form the water-repellant ink-receptive areas on a water-receptive ink-repellant background. For example, typical lithographic printing plates are disclosed in e.g. EP-423,399, EP-410,500, US-P-4,297,429, US-P-4,297,430, US-P-4,501,811, US-P-4,784,933, US-P-5,059,508 etc.

The DTR-image can be formed in the image-receiving layer of a sheet or web material which is a separate element with respect to the photographic silver halide emulsion material (a so-called two-sheet DTR element) or in the image-receiving layer of a so-called single-support-element, also called mono-sheet element, which contains at least one photographic silver halide emulsion layer integral with an image-receiving layer in waterpermeable relationship therewith. It is the latter mono-sheet version which is preferred for the preparation of offset printing plates by the DTR method.

According to a preferred embodiment of the present invention an imaging element is provided that can be imaged according to the DTR-method so that a lithographic printing plate can be obtained. Said imaging element comprises on a support in the order given a silver halide emulsion layer sensitized to red light by means of a sensitizing dye having a maximum absorption between 600nm and 700nm characterized in that said silver halide emulsion further comprises a salt of a group IIa metal, added during the spectral sensitization in an amount of at least 5*10⁻³ mole/mole of silver halide and a physical development nuclei layer. Preferably the imaging element also comprises a base layer between the support and the silver halide emulsion layer as described above. A further intermediate layer between the silver halide emulsion layer and the layer containing physical development nuclei may also be provided.

A matting agent is preferably included in said base layer and optionally in small amounts i.e. from 1 to 20% by weight in the silver halide emulsion layer. When the matting agent is included in the silver halide emulsion layer it is preferable added to the emulsion after spectral sensitization of the silver halide emulsion to avoid adsorption of the sensitizer to the matting agent. Suitable matting agents for use in accordance with the present embodiment are water insoluble inorganic or organic particles having an average diameter between 1µm and 10µm most preferably between 4µm and 8µm. A preferred matting agent is silica.

The layer containing physical development nuclei is preferably free of hydrophilic binder but may comprise small amounts upto 30% by weight of the total weight of said layer of a hydrophilic colloid e.g. polyvinyl alcohol to improve the hydrophilicity of the surface.

Preferably used supports in connection with the present embodiment are paper supports or resin supports e.g. polyester film supports.

To obtain a lithographic printing plate the above described DTR-imaging element is information-wise exposed using a scanning exposure in the spectrum of 600nm to 700nm and is subsequently developed with an alkaline processing liquid in the presence of developing agent(s) and silver halide solvent(s). Said development step is preferably followed by a neutralization of the surface of the imaged element by guiding the element through a neutralization liquid having a pH between 4 and 7. The neutralization liquid preferably contains a buffer e.g. a phosphate buffer, a citrate buffer or mixture thereof. The neutralization solution can further contain bactericides, e.g. phenol, thymol or 5-bromo-5-nitro-1,3-dioxan as described in EP-150,517, wetting agents e.g. saponins or pluronics etc.. The liquid can also contain substances which influence the hydrophobic / hydrophilic balance of the printing plate obtained after processing of the DTR element, e.g. silica. Finally the neutralization solution can contain wetting agents, preferably compounds containing perfluorinated alkyl groups.

To improve the differentiation between the hydrophobic silver image and the hydrophilic background the alkaline processing liquid and/or neutralization liquid preferably contain one or more hydrophobizing agents, e.g. those described in US-P-3,776,728, and US-P-4,563,410. Preferred compounds are 5-n-heptyl-2-mercapto-1,3,4,-oxadiazol and 3-mercapto-4-acetamido-5-n-heptyl-1,2,4-triazole.

According to an alternative embodiment of the present invention a lithographic printing plate can be obtained by means of the DTR-process using an imaging element comprising in the order given a grained and anodized aluminium support, an optional layer of physical development nuclei and a silver halide emulsion layer sensitized to red light by means of a sensitizing dye having a maximum absorption between 600nm and 700nm characterized in that said silver halide emulsion further comprises a salt of a group IIa metal,added during the spectral sensitization in an amount of at least 5∗10⁻³ mole/mole of silver halide. The imaging element of the present embodiment may be imaged using an information-wise exposure as described above followed by a development step in the presence of development agent(s) and silver halide solvent(s) so that a silver image is formed in the physical development nuclei layer or directly on the aluminium support. Subsequently the silver halide emulsion layer and any other optional hydrophilic layers are removed by rinsing the imaged element with water so that the silver image is exposed. Finally the hydrophobic character of the silver image is preferably improved using a finishing liquid comprising hydrophobizing agents as described above.

To facilate the removal of the silver halide emulsion layer it is advantageous to provide a hydrophilic layer between the aluminium support and the silver halide emulsion layer. Preferably used hydrophilic layers for this purpose are layers comprising a hydrophilic non-proteinic film-forming polymers e.g. polyvinyl alcohol, polymer beads e.g. poly(meth)acrylate beads or mixtures thereof. Such type of layers are disclosed in EP-A-483415 and EP-A-410500.

The present invention is illustrated by the following examples without limiting it thereto. All parts are by weight unless otherwise specified. The spectral sensitizers and supersensitizers used in the following examples are shown in the description above and are referred to by the number mentioned besides their structure.

### EXAMPLE 1

A gelatin silver halide emulsion A was prepared using the double jet precipitation by slowly mixing whilst stirring an aqueous solution of AgNO₃ having a concentration of 2 mole/l, and an aqueous solution having a concentration of 1.7 mole/l of NaCl, 0.48 mole/l of KBr and 0.001 mole/l of KI. Before the precipitation 5*10⁻⁴ mole/l of sodium hexachlororhodate was added to the silver nitrate solution. In a second part of the precipitation an aqueous solution of AgNO₃ having a concentration of 1 mole/l was slowly mixed with a aqueous solution of NaCl at a concentration of 1.3 mole/l.

The temperature during the silver halide formation was 55°C. The obtained core-shell emulsion was cooled, flocculated and washed. Gelatin was added in an amount sufficient to reach a ratio of 2/3 by weight of gelatin to silver halide, expressed as equivalent amount of silver nitrate.

The obtained emulsion with an average grain size of 0.4 µm (diameter of a sphere with equivalent volume) has a Cl/Br/I content of 0.84/0.157/0.003 mole per mole AgNO₃.

Subsequently a chemical ripening was carried out in a conventional way, known to those skilled in the art, using thiosulphate and gold salts.

The emulsion was sensitised for the red spectral region by following the procedure : first compound ((4-1)) the supersensitizing compound is added in an amount of 5*10⁻⁴ mole per mole of AgNO₃ and then 0.22*10⁻³ mole per mole of AgNO₃ of a red sensitizing dye.

Comparative photographic DTR monosheet materials were prepared as follows. One side of a film support is coated with two layers by double layer curtain coating. The layer nearer to the support is the antihalation layer and the other is the emulsion layer. The emulsion was coated at an amount of silver halide corresponding to 1.5 g AgNO₃/m². This emulsion layer contained 0.1 g/m² of 1-phenyl-3-pyrazolidinon and 1.0 g/m² of gelatin.

The antihalation layer contained carbon black, silica particles of 5 micron average size and gelatin at 3 g/m². The gelatin was lime-treated, substantially free of calcium ions (1000 ppm or less) and of the high viscosity type (not less than 85 m.Pa.s at 40°C for a 10% solution).

After drying these layers were subjected to a temperature of 40°C for 5 days and then overcoated with a layer containing PdS nuclei, hydrochinon at 0.4 g/m² and formaldehyde at 100 mg/m².

Photographic materials according to the invention were prepared as described above with the exception that during spectral sensitization of the silver halide emulsion before the addition of the red sensitizing dye Ca(NO₃)₂.4H₂O is added in an amount of 1*10⁻¹ mole per mole of AgNO₃. The type of red sensitizing dye is mentioned in table 5.

The following processing solutions were prepared :

| Activator solution 1 | |
|---|---|
| sodium hydroxide | 25 g |
| sodium sulphite anh. | 40 g |
| potassium thiocyanate | 20 g |
| 3-mercapto-4-acetamido-5-n-heptyl-1,2,4-triazole | 0.5 g |
| water to make | 1 l |

| Activator solution 2 | |
|---|---|
| potassium hydroxide | 35 g |
| sodium sulphite anh. | 35 g |
| 1,2,4-trimethyl-1,2,4-triazolium-3-thiolate | 250 g |
| 2-Aminoethyl-aminoethanol | 10 g |
| 2-mercapto-5-n-heptyl-oxa 3,4-diazole | 0.5 g |
| water to make | 1 l |

| Neutralization solution | |
|---|---|
| citric acid | 10 g |
| sodium citrate | 35 g |
| cysteine | 1 g |
| sodium sulphite anh. | 5 g |
| phenol | 50 mg |
| water to make | 1 l |

| Dampening solution | |
|---|---|
| water | 880 ml |
| citric acid | 6 g |
| boric acid | 8.4 g |
| sodium sulphate anh. | 25 g |
| ethyleneglycol | 100 g |
| colloidal silica | 28 g |

The above described DTR materials were image-wise exposed in a HeNe laser image setter. Subsequently the material was treated with the described activator solution for 10 seconds at 30°C, thereupon treated with the described neutralization solution at 25°C and finally dried.

The printing plates thus prepared were mounted on an offset printing machine (AB DICK 350 CD - trade name for offset printing machine manufactured by AB DICK Co.). During the printing run the described dampening solution was used in each case.

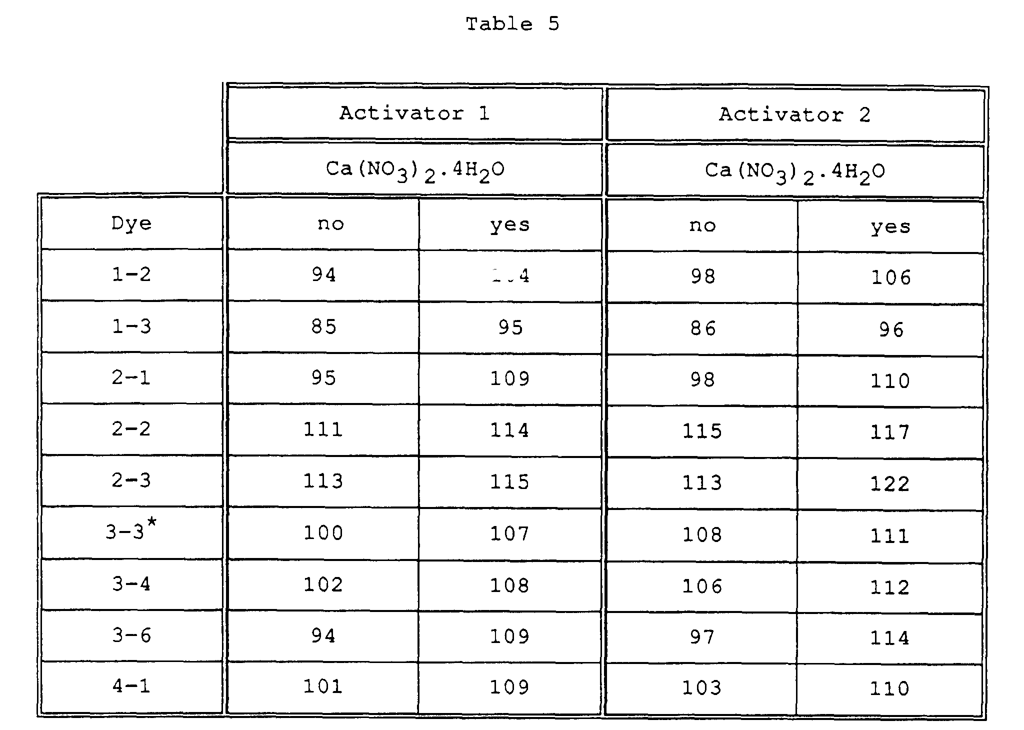

The sensitivity is expressed relative to the comparitive photographic material* that contains as red sensitizing dye compound 3-3 but does not contain the calcium salt and that is given a value of 100. A lower number indicates a decrease in sensitivity while a higher number indicates an increase. A value higher by 30 means a doubling of the sensitivity with respect to the reference.

It can be seen from table 5 that the sensitivity of the photographic material in the red region is increased by the addition of a calcium salt during the spectral sensitization. All of the photographic materials in table 5 yielded a printing plate of high printing endurance.

## Claims

1. A photographic material comprising a silver halide emulsion layer sensitized to red light by means of an anionic sensitizing dye having a maximum absorption between 600nm and 700nm characterized in that said silver halide emulsion further comprises a salt of a group IIa metal,added during the spectral sensitization in an amount of at least 5*10⁻³ mole/mole of silver halide, the anion of said salt can form with a silver cation a salt with a solubility product in water higher than 10⁻⁸ mole²/liter².

2. A photographic material according to claim 1 wherein said red sensitizing dye corresponds to one of the following formulas (I) to (IV): 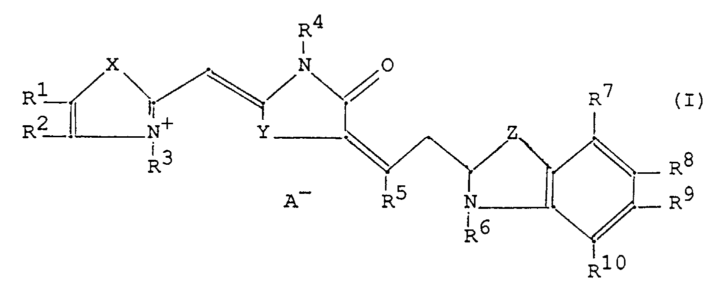 wherein each of X and Z independently represents S , Se or O, Y represents S, Se or NR with R representing a substituted or non-substituted alkyl, a substituted or non-substituted cycloalkyl or a substituted or non-substituted aryl, each of R³, R⁴ and R⁶ independently represents allyl or a substituted or non-substituted C₁-C₄ alkyl, R⁵ represents hydrogen, a substituted or non-substituted alkyl, a substituted or non-substituted aralkyl or a substituted or non-substituted aryl, R¹ and R² each independently represents a substituted or non-substituted alkyl, a substituted or non-substituted aralkyl, a substituted or non-substituted aryl, a substituted or non-substituted alkoxy or R¹ and R² together represent the necessary atoms to complete a ring system, including a fused ring system that may contain one or more heteroatoms, that may be aromatic and that may be substituted by one or more substituents selected from the group consisting of a substituted or non-substituted alkyl, halogen, and a substituted or non-substituted alkoxy, each of R⁷, R⁸, R⁹, R¹⁰ independently represents hydrogen, a substituent selected from the group consisting of a substituted or non-substituted alkyl, a substituted or non-substituted aralkyl, a substituted or non-substituted aryl, halogen, -CN, ester, hydroxyl, a substituted or non-substituted alkoxy, -NH₂, -NHR', -NR'₂ with R' representing a substituted or non-substituted alkyl, a substituted or non-substituted cycloalkyl or a substituted or non-substituted aryl or R⁷ and R⁸ or R⁸ and R⁹ or R⁹ and R¹⁰ together represent the necessary atoms to complete a ring system, including a fused ring system that may contain one or more heteroatoms and that may be aromatic, and A⁻ represents an anion, e.g. F⁻, Cl⁻, Br⁻, I⁻, toluene sulphonate, ClO₄⁻,
and wherein at least one of the substituents represented by R³, R⁴ or R⁶ are C₁-C₄ alkyl substituted with a COOM or SO₃M group with M representing hydrogen, a metal cation or NH₄⁺; 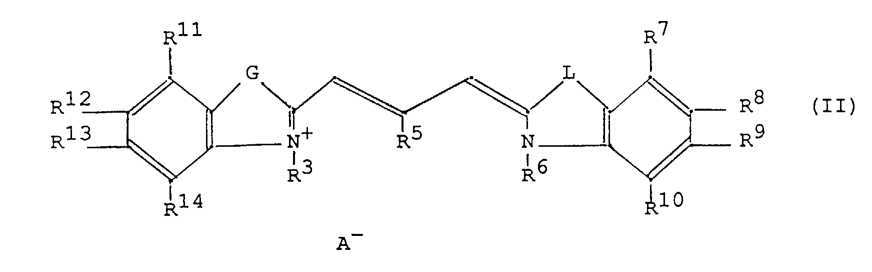 wherein R³, R⁵, R⁶, R⁷, R⁸, R⁹, R¹⁰ and A⁻ have the same meaning as defined above, each of G and L independently represents S, Se, O or C(CH₃)₂ and R¹¹, R¹², R¹³ and R¹⁴ independently from R⁷, R⁸, R⁹ and R¹⁰ may have one of the significances given for R⁷, R⁸, R⁹ and R¹⁰ and wherein at least one of the substituents represented by R³, R⁴ or R⁶ are C₁-C₄ alkyl substituted with a COOM or SO₃M group with M having the same meaning as defined above; 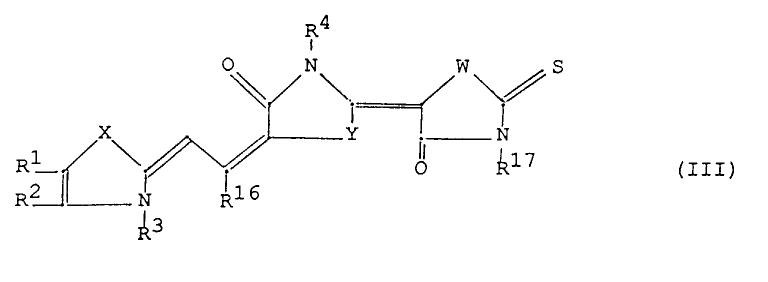 wherein X, Y, R¹, R², R³, R⁴, and have the same meaning as defined above, W represents S, Se or NR¹⁵ with R¹⁵ representing an allyl or a substituted or non-substituted C₁-C₄ alkyl,
R¹⁶ independently from R¹⁵ has the same meaning as R¹⁵ and R¹⁷ independently from R¹⁵ has the same meaning as R¹⁵ or represents a substituted or non-substituted aryl
and wherein at least one of the substituents represented by R³, R⁴, R¹⁵, R¹⁶ or R¹⁷ are C₁-C₄ alkyl substituted with a COOM or SO₃M group with M having the same meaning as defined above; 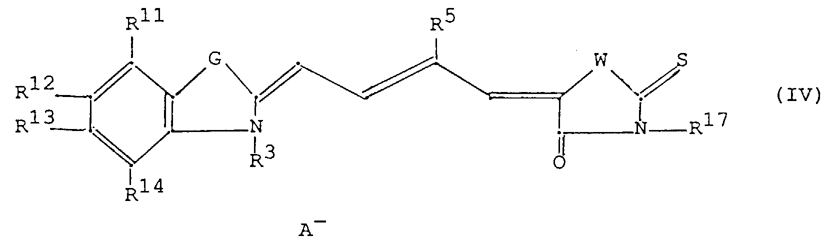 wherein G, W, R³, R⁵, R¹¹, R¹², R¹³, R¹⁴ and R¹⁷ have the same meaning as defined above
and wherein at least one of the substituents represented by R³ or R¹⁷ are C₁-C₄ alkyl substituted with a COOM or SO₃M group with M having the same meaning as defined above;

3. A photographic material according to claim 1 or 2 wherein said salt of a group IIa metal is a water-soluble magnesium or calcium salt.

4. A photographic material according to any of claims 1 to 3 wherein said salt is used in an amount between 1*10⁻² mole/mole of silver halide and 1 mole/mole of silver halide.

5. A photographic material according to any of the claims 1 to 4 wherein said silver halide emulsion comprises at least 70 mole% of AgCl.

6. A photographic material according to any of the claims 1 to 5 further comprising a layer containing physical development nuclei.

7. A method for obtaining an image comprising:
- high intensity short time information-wise exposing a photographic material as defined in any of claims 1 to 6 using a light source emitting light between 600nm and 700nm and
- developing said information-wise exposed imaging element in the presence of developing agent(s).

8. A method for obtaining a lithographic printing plate comprising:
- high intensity short time information-wise exposing a photographic material as defined in claim 7 using a light source emitting light between 600nm and 700nm and
- developing said information-wise exposed imaging element in the presence of developing agent(s) and silver halide solvent(s).

## Patentansprüche

1. Ein fotografisches Material mit einer Silberhalogenid-Emulsionsschicht, die mittels eines anionischen Sensibilisierungsfarbstoffes mit einer maximalen Absorption zwischen 600 nm und 700 nm für Rotlicht empfindlich gemacht ist, dadurch gekennzeichnet, daß die Silberhalogenidemulsion weiterhin ein während der spektralen Sensibilisierung zugesetztes Salz eines Metalls der Gruppe IIa in einer Menge von wenigstens 5*10⁻³ Mol/Mol Silberhalogenid enthält, wobei das Anion des Salzes mit einem Silberkation ein Salz mit einem Löslichkeitsprodukt in Wasser von mehr als 10⁻⁸ Mol²/Liter² bilden kann.

2. Fotografisches Material nach Anspruch 1, dadurch gekennzeichnet, daß der rotsensibilisierende Farbstoff einer der folgenden Formeln (I) bis (IV) entspricht : 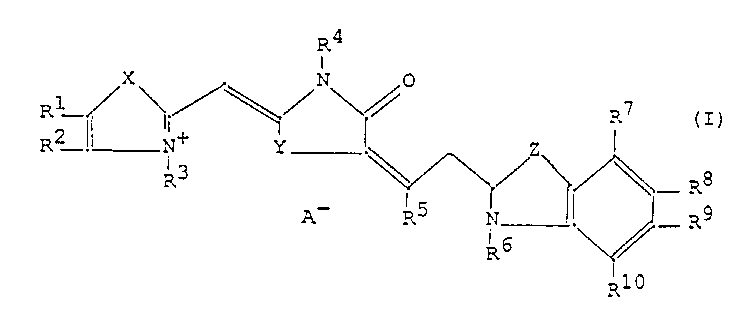 in der bedeuten :
X und Z jeweils unabhängig voneinander S, Se oder O, Y S, Se oder NR, wobei R eine substituierte oder nicht-substituierte Alkylgruppe, eine substituierte oder nicht-substituierte Cycloalkylgruppe oder eine substituierte oder nicht-substituierte Arylgruppe bedeutet,
R³, R⁴ und R⁶ jeweils unabhängig voneinander eine Allylgruppe oder eine substituierte oder nicht-substituierte C₁-C₄-Alkylgruppe,
R⁵ ein Wasserstoffatom, eine substituierte oder nicht-substituierte Alkylgruppe, eine substituierte oder nicht-substituierte Aralkylgruppe oder eine substituierte oder nicht-substituierte Arylgruppe,
R¹ und R² jeweils unabhängig voneinander eine substituierte oder nicht-substituierte Alkylgruppe, eine substituierte oder nicht-substituierte Aralkylgruppe, eine substituierte oder nicht-substituierte Arylgruppe, eine substituierte oder nicht-substituierte Alkoxygruppe oder R¹ und R² zusammen die zum Ergänzen eines Ringsystems, einschließlich eines anellierten Ringsystems, benötigten Atome, wobei das Ringsystem ein oder mehrere Heteroatome enthalten kann, aromatisch sein kann und durch einen oder mehrere Substituenten aus der Gruppe bestehend aus einer substituierten oder nicht-substituierten Alkylgruppe, einem Halogenatom und einer substituierten oder nicht-substituierten Alkoxygruppe substituiert sein kann,
R⁷, R⁸, R⁹ und R¹⁰ jeweils unabhängig voneinander ein Wasserstoffatom, einen Substituenten aus der Gruppe bestehend aus einer substituierten oder nicht-substituierten Alkylgruppe, einer substituierten oder nicht-substituierten Aralkylgruppe, einer substituierten oder nicht-substituierten Arylgruppe, einem Halogenatom, einer -CN-Gruppe, einer Estergruppe, einer Hydroxylgruppe, einer substituierten oder nicht-substituierten Alkoxygruppe, -NH₂, -NHR', -NR'₂, wobei R' eine substituierte oder nicht-substituierte Alkylgruppe, eine substituierte oder nicht-substituierte Cycloalkylgruppe oder eine substituierte oder nicht-substituierte Arylgruppe bedeuten kann, oder R⁷ und R⁸ oder R⁸ und R⁹ oder R⁹ und R¹⁰ zusammen die zum Ergänzen eines Ringsystems, einschließlich eines anellierten Ringsystems, benötigten Atome, wobei das Ringsystem ein oder mehrere Heteroatome enthalten und aromatisch sein kann, und
A⁻ ein Anion, z.B. F⁻, Cl⁻, Br⁻, I⁻, Toluolsulfonat und ClO₄⁻, und wobei wenigstens einer der durch R³, R⁴ oder R⁶ dargestellten Substituenten eine durch eine COOM- oder SO₃M-Gruppe substituierte C₁-C₄-Alkylgruppe darstellt, wobei M ein Wasserstoffatom, ein Metallkation oder NH₄⁺ bedeutet, 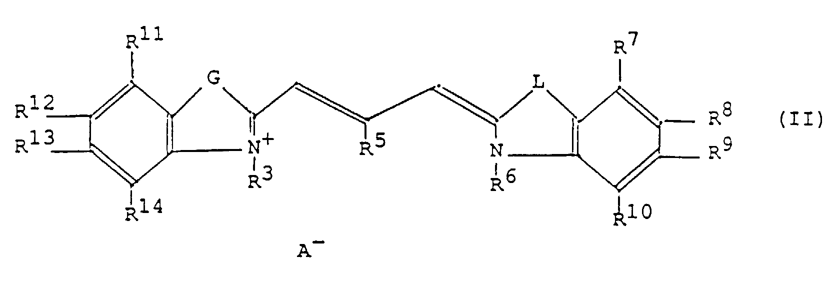 in der R³, R⁵, R⁶, R⁷, R⁸, R⁹, R¹⁰ und A⁻ die diesen Symbolen oben zugemessene Bedeutung haben, G und L jeweils unabhängig voneinander S, Se, O oder C(CH₃)₂ bedeuten und R¹¹, R¹², R¹³ und R¹⁴ unabhängig von R⁷, R⁸, R⁹ und R¹⁰ eine der R⁷, R⁸, R⁹ und R¹⁰ zugemessenen Bedeutungen haben können und wobei wenigstens einer der durch R³ oder R⁶ dargestellten Substituenten eine durch eine COOM- oder SO₃M-Gruppe substituierte C₁-C₄-Alkylgruppe bedeutet, wobei M die diesem Symbol oben zugemessene Bedeutung hat, 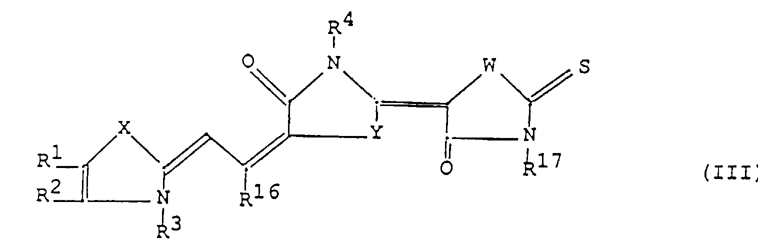 in der X, Y, R¹, R², R³ und R⁴ die diesen Symbolen oben zugemessene Bedeutung haben, W S, Se oder NR¹⁵ bedeutet, wobei R¹⁵ eine Allylgruppe oder eine substituierte oder nicht-substituierte C₁-C₄-Alkylgruppe bedeutet, R¹⁶ unabhängig von R¹⁵ die R¹⁵ zugemessene Bedeutung hat und R¹⁷ unabhängig von R¹⁵ die R¹⁵ zugemessene Bedeutung hat oder eine substituierte oder nicht-substituierte Arylgruppe bedeutet, und wobei wenigstens einer der durch R³, R⁴, R¹⁵, R¹⁶ oder R¹⁷ dargestellten Substituenten eine durch eine COOM- oder SO₃M-Gruppe substituierte C₁-C₄-Alkylgruppe bedeutet, wobei M die diesem Symbol oben zugemessene Bedeutung hat, 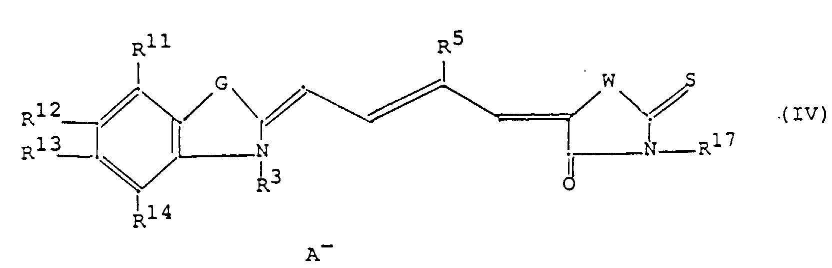 in der G, W, R³, R⁵, R¹¹, R¹², R¹³, R¹⁴ und R¹⁷ die diesen Symbolen oben zugemessene Bedeutung haben und wobei wenigstens einer der durch R³ oder R¹⁷ dargestellten Substituenten eine durch eine COOM- oder SO₃M-Gruppe substituierte C₁-C₄-Alkylgruppe bedeutet, wobei M die diesem Symbol oben zugemessene Bedeutung hat.

3. Fotografisches Material nach Anspruch 1 oder 2, dadurch gekennzeichnet, daß das Salz eines Metalls der Gruppe IIa ein wasserlösliches Magnesium- oder Calciumsalz ist.

4. Fotografisches Material nach irgendeinem der Ansprüche 1 bis 3, dadurch gekennzeichnet, daß das Salz in einer Menge zwischen 1*10⁻² Mol/Mol Silberhalogenid und 1 Mol/Mol Silberhalogenid verwendet wird.

5. Fotografisches Material nach irgendeinem der Ansprüche 1 bis 4, dadurch gekennzeichnet, daß die Silberhalogenidemulsion wenigstens 70 mol-% AgCl enthält.

6. Fotografisches Material nach irgendeinem der Ansprüche 1 bis 5, das weiterhin eine physikalische Entwicklungskeime enthaltende Schicht enthält.

7. Bildherstellungsverfahren, das folgende Stufen umfaßt :
- informationsmäßige Kurzzeitbelichtung hoher Intensität eines wie in irgendeinem der Ansprüche 1 bis 6 definierten fotografischen Materials unter Verwendung einer Licht im Wellenbereich zwischen 600 nm und 700 nm emittierenden Lichtquelle und
- die Entwicklung des informationsmäßig belichteten bilderzeugenden Elements in Gegenwart einer oder mehrerer Entwicklersubstanzen.

8. Verfahren zur Herstellung einer lithografischen Druckplatte, das folgende Stufen umfaßt :
- informationsmäßige Kurzzeitbelichtung hoher Intensität eines in Anspruch 7 definierten fotografischen Materials unter Verwendung einer Licht im Wellenbereich zwischen 600 nm und 700 nm emittierenden Lichtquelle und
- die Entwicklung des informationsmäßig belichteten bilderzeugenden Elements in Gegenwart einer oder mehrerer Entwicklersubstanzen und eines oder mehrerer Silberhalogenid-Lösungsmittel.

## Revendications

1. Matériau photographique comprenant une couche d'émulsion à l'halogénure d'argent qui a été rendue sensible à la lumière rouge à l'aide d'un colorant sensibilisateur de type anionique possédant une absorption maximale entre 600 nm et 700 nm, caractérisé en ce que ladite émulsion à l'halogénure d'argent comprend en outre un sel d'un métal du groupe IIa ajouté au cours de la sensibilisation spectrale en une quantité d'au moins 5*10⁻³ mole/mole d'halogénure d'argent, l'anion dudit sel pouvant former, avec un cation d'argent, un sel possédant un produit de solubilité dans l'eau supérieur à 10⁻⁸ mole²/litre².

2. Matériau photographique selon la revendication 1, dans lequel ledit colorant sensibilisateur dans la région rouge du spectre répond à une des formules (I) à (IV) ci-après: 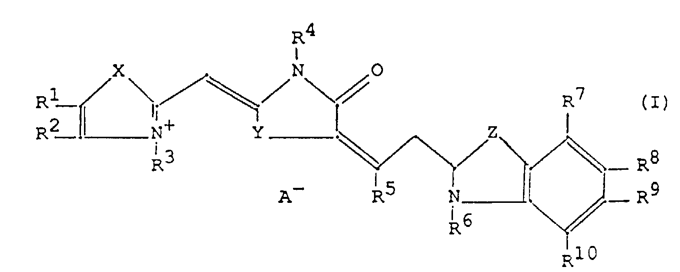 dans laquelle X et Y représentent respectivement, indépendamment l'un de l'autre, un atome de soufre, un atome de sélénium ou un atome d'oxygène, Y représente un atome de soufre, un atome de sélénium ou un groupe NR où R représente un groupe alkyle substitué ou non substitué, un groupe cycloalkyle substitué ou non substitué ou un groupe aryle substitué ou non substitué, R³, R⁴ et R⁶ représentent respectivement, indépendamment l'un de l'autre, un groupe allyle ou un groupe alkyle en C₁-C₄ substitué ou non substitué, R⁵ représente un atome d'hydrogène, un groupe alkyle substitué ou non substitué, un groupe aralkyle substitué ou non substitué ou un groupe aryle substitué ou non substitué, R¹ et R² représentent respectivement, indépendamment l'un de l'autre, un groupe alkyle substitué ou non substitué, un groupe aralkyle substitué ou non substitué, un groupe aryle substitué ou non substitué, un groupe alcoxy substitué ou non substitué, ou bien R¹ et R² représentent ensemble les atomes nécessaires pour compléter un système cyclique, y compris un système cyclique condensé qui peut contenir un ou plusieurs hétéroatomes, qui peut être de type aromatique et qui peut contenir un ou plusieurs substituants identiques ou différents choisis parmi le groupe constitué par un groupe alkyle substitué ou non substitué, un atome d'halogène et un groupe alcoxy substitué ou non substitué, R⁷, R⁸, R⁹ et R¹⁰ représentent respectivement indépendamment l'un de l'autre un atome d'hydrogène, un substituant choisi parmi le groupe constitué par un groupe alkyle substitué ou non substitué, un groupe aralkyle substitué ou non substitué, un groupe aryle substitué ou non substitué, un atome d'halogène, un groupe -CN, un groupe ester, un groupe hydroxyle, un groupe alcoxy substitué ou non substitué, un groupe -NH₂, un groupe -NHR', un groupe -NR'₂, R' représentant un groupe alkyle substitué ou non substitué, un groupe cycloalkyle substitué ou non substitué ou un groupe aryle substitué ou non substitué, ou bien R⁷ et R⁸ ou R⁸ et R⁹ ou R⁹ et R¹⁰ représentent ensemble les atomes nécessaires pour compléter un système cyclique, y compris un système cyclique condensé qui peut contenir un ou plusieurs hétéroatomes et qui peut être de type aromatique et A⁻ représente un anion, par exemple F⁻, Cl⁻, Br⁻, I⁻, un toluènesulfonate, ClO₄⁻,
et dans laquelle au moins un des substituants représentés par R³, R⁴ ou R⁶ représente un groupe alkyle en C₁-C₄ contenant, à titre de substituant, un ou plusieurs groupes COOM ou SO₃M, M représentant un atone d'hydrogène, un cation métallique ou un groupe NH₄⁺; 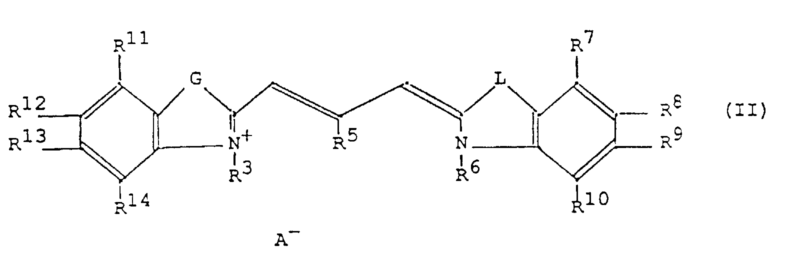 dans laquelle R³, R⁵, R⁶, R⁷, R⁸, R⁹, R¹⁰ et A⁻ ont la même signification que celle définie ci-dessus, G et L représentent respectivement, indépendamment l'un de l'autre, un atome de soufre, un atome de sélénium, un atome d'oxygène ou un groupe C(CH₃)₂ et R¹¹, R¹², R¹³ et R¹⁴, indépendamment de R⁷, R⁸, R⁹ et R¹⁰, peuvent avoir une des significations données pour R⁷, R⁸, R⁹ et R¹⁰, et dans laquelle au moins un des substituants représentés par R³, R⁴ ou R⁶ représente un groupe alkyle en C₁-C₄ contenant, à titre de substituant, un ou plusieurs groupes COOM ou SO₃M, M ayant la même signification que celle définie ci-dessus; 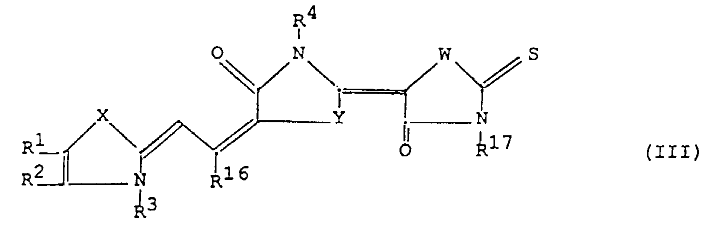 dans laquelle X, Y, R¹, R², R³, R⁴ ont la même signification que celle définie ci-dessus, W représente un atome de soufre, un atome de sélénium ou un groupe NR¹⁵ où R¹⁵ représente un groupe allyle ou un groupe alkyle en C₁-C₄ substitué ou non substitué, R¹⁶, indépendamment de R¹⁵, a la même signification que celle de R¹⁵ et R¹⁷, indépendamment de R¹⁵, a la même signification que celle de R¹⁵ ou représente un groupe aryle substitué ou non substitué,
et dans laquelle au moins un des substituants représentés par R³, R⁴, R¹⁵, R¹⁶ ou R¹⁷ représente un groupe alkyle en C₁-C₄ portant, à titre de substituant, un ou plusieurs groupes COOM ou SO₃M, M ayant la même signification que celle définie ci-dessus; 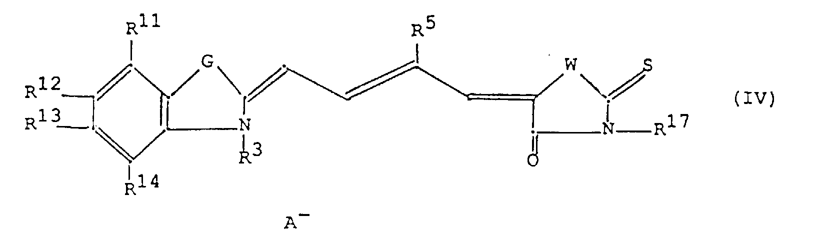 dans laquelle G, W, R³, R⁵, R¹¹, R¹², R¹³, R¹⁴ et R¹⁷ ont la même signification que celle définie ci-dessus,
et dans laquelle au moins un des substituants représentés par R³ ou R¹⁷ représente un groupe alkyle en C₁-C₄ portant, à titre de substituant, un ou plusieurs groupes COOM ou SO₃M, M ayant la même signification que celle définie ci-dessus.

3. Matériau photographique selon la revendication 1 ou 2, dans lequel ledit sel d'un métal du groupe IIa est un sel de magnésium ou de calcium hydrosoluble.

4. Matériau photographique selon l'une quelconque des revendications 1 à 3, dans lequel ledit sel est utilisé en une quantité entre 1*10⁻² mole par mole d'halogénure d'argent et 1 mole/mole d'halogénure d'argent.

5. Matériau photographique selon l'une quelconque des revendications 1 à 4, dans lequel ladite émulsion à l'halogénure d'argent comprend du AgCl à concurrence d'au moins 70 moles %.

6. Matériau photographique selon l'une quelconque des revendications 1 à 5, comprenant en outre une couche contenant des germes de développement physique.

7. Procédé pour former une image, comprenant le fait de
- exposer en forme d'informations pendant un bref laps de temps dans des conditions de forte intensité, un matériau photographique tel que défini dans l'une quelconque des revendications 1 à 6 en utilisant une source lumineuse émettant de la lumière entre 600 nm et 700 nm, et
- développer ledit élément de formation d'image exposé en forme d'informations en présence d'un ou de plusieurs agents développateurs.

8. Procédé pour l'obtention d'un cliché d'impression lithographique, comprenant le fait de:
- exposer en forme d'informations pendant un bref laps de temps dans des conditions de forte intensité, un matériau photographique tel que défini à la revendication 7 en utilisant une source lumineuse émettant de la lumière entre 600 nm et 700 nm, et
- développer ledit élément de formation d'image exposé en forme d'informations, en présence d'un ou de plusieurs agents développateurs et d'un ou de plusieurs solvants pour l'halogénure d'argent.
